Europäisches Patentamt

European Patent Office

Office européen des brevets

(11) Publication number: **0 036 743**
**B1**

## (12) EUROPEAN PATENT SPECIFICATION

(45) Date of publication of patent specification: **19.12.84**

(21) Application number: **81301110.3**

(22) Date of filing: **17.03.81**

(51) Int. Cl.³: **G 11 C 8/00**, G 11 C 11/24,
H 03 K 19/08, H 03 K 3/353

(54) TTL- to MOS-level address buffer circuit.

(30) Priority: **18.03.80 JP 34382/80**

(43) Date of publication of application:
**30.09.81 Bulletin 81/39**

(45) Publication of the grant of the patent:
**19.12.84 Bulletin 84/51**

(84) Designated Contracting States:
**DE FR GB NL**

(56) References cited:
DE-A-2 818 350
US-A-3 940 747
US-A-4 038 646
US-A-4 087 704
US-A-4 104 733
US-A-4 110 639
US-A-4 110 842
US-A-4 149 099

The file contains technical information
submitted after the application was filed and
not included in this specification

(73) Proprietor: **FUJITSU LIMITED**
**1015, Kamikodanaka Nakahara-ku**
**Kawasaki-shi Kanagawa 211 (JP)**

(72) Inventor: **Nakano, Tomio**
**1-11-2-12-404 Shirahatadai Takatsu-ku**
**Kawasaki-shi Kanagawa 213 (JP)**

(74) Representative: **Rackham, Stephen Neil et al**
**GILL JENNINGS & EVERY 53-64 Chancery Lane**
**London WC2A 1HN (GB)**

(56) References cited:
IEEE INTERNATIONAL SOLID-STATE CIRCUITS
CONFERENCE, February 15, 1979, NEW YORK
(US), LEE et al.: "A 80ns 5V-Only Dynamic
RAM" pages 142-143
ESSL et al.: "A 64 Kb VMOS RAM", pages
148-149
IEEE INTERNATIONAL SOLID-STATE CIRCUITS
CONFERENCE, February 16, 1977, NEW YORK
(US), O'CONNELL et al.: "A 4K Static Clocked
and Nonclocked RAM Design" pages 14-15
IEEE INTERNATIONAL SOLID-STATE CIRCUITS
CONFERENCE, February 16, 1978, NEW YORK
(US), LEACH et al.: "A IKx8-Bit 5V-only Static
RAM" pages 104-105

Courier Press, Leamington Spa, England.

## Description

The present invention relates generally to an address buffer circuit for use in a high-speed MOS (Metal Oxide Semiconductor) dynamic RAM (Random Access Memory) device.

In general, address signals of a TTL (Transistor Transistor Logic) level are supplied from an external circuit to a MOS dynamic RAM device. In this case, the low and high potentials of a TTL level are, for example, 0.8 volts and from 2.0 to 2.4 volts, respectively. On the other hand, within the MOS dynamic RAM device, the signals have to be of a MOS level whose low and high potentials are, for example, 0 volts and 5 volts, respectively. Such signals are used for accessing one memory cell among a memory cell matrix. Therefore, it is necessary to convert address signals of a TTL level into address signals of a MOS level. For carrying out this conversion, the device incorporates an address buffer circuit.

One conventional address buffer circuit is shown in the report of the IEEE International Solid-State Circuits Conference held on 15th February 1979 in New York, in a paper by Lee et al, entitled "A 80ns 5V-Only Dynamic Ram" on pages 142—143. This address buffer circuit for converting a TTL level address signal into an MOS level address signal and its inverted signals comprises first and second power supplies; a pre-amplifier, connected to the second power supply, for receiving the TTL level address signal; a main amplifier connected to outputs of the pre-amplifier and including a first flip-flop; an output circuit coupled to outputs of the main amplifier and including a second flip-flop for producing the MOS level address signal and its inverted signal. To operate this address buffer circuit, various kinds of clock signals are necessary.

However, in the above-mentioned conventional address buffer circuit, the circuit is of a relatively large scale. In addition the operational speed is low, since the input circuit includes a capacitive resistive network and this has a particular time-constant. Further, the operation of the circuit is unstable, since a reference voltage which is dependent upon a power supply voltage is necessary and in addition malfunction of the output circuit may be invited by a dynamic operation.

According to this invention in such an address buffer the pre-amplifier comprises a first enhancement type transistor having its drain connected to a first input of the main amplifier and its gate arranged to receive a first clock signal, a second enhancement type transistor having its drain connected to the source of the first transistor, its source connected to the second power supply and its gate arranged to receive the level address signal, a third enhancement type transistor having its drain connected to a second input of the main amplifier and its gate arranged to receive the first clock signal and, a fourth depletion type transistor having its drain connected to the source of the third transistor and its gate and source commonly connected to the second power supply; the first flip-flop in the main amplifier has a first terminal connected to the first power supply and a second terminal; and the address buffer circuit also includes a circuit, connected between the first and second power supplies, for defining the potential of the second terminal of the first flip-flop and a circuit coupling the main amplifier to the output circuit, the circuit comprising transfer gate transistors having their drains connected to the outputs of the main amplifier, their gates arranged to receive a second clock signal and their sources connected to one of the inputs of the output circuit and charging the second flip-flop of the output circuit from the main amplifier when the output circuit is in a stand-by state, and electrically disconnecting the output circuit from the main amplifier when the output circuit is in an active state.

The address buffer circuit in accordance with this invention is small in size and both stable and of high speed operation.

An example of an address buffer circuit in accordance with this invention will now be described and contrasted with a conventional circuit with reference to the accompanying drawings; in which:—

Figure 1 is a block diagram of a conventional MOS dynamic RAM device;

Figure 2 is a circuit diagram of a conventional address buffer circuit;

Figure 3 is a timing diagram showing the internal clock signals supplied to the conventional address buffer circuit;

Figure 4 is a timing diagram showing the signals appearing in the conventional address buffer circuit;

Figure 5 is a circuit diagram of an address buffer circuit in accordance with the present invention;

Figure 6 is a timing diagram showing the internal clock signals supplied to the address buffer circuit in accordance with the present invention; and,

Figure 7 is a timing diagram showing the signals appearing in address buffer circuits in accordance with the present invention;

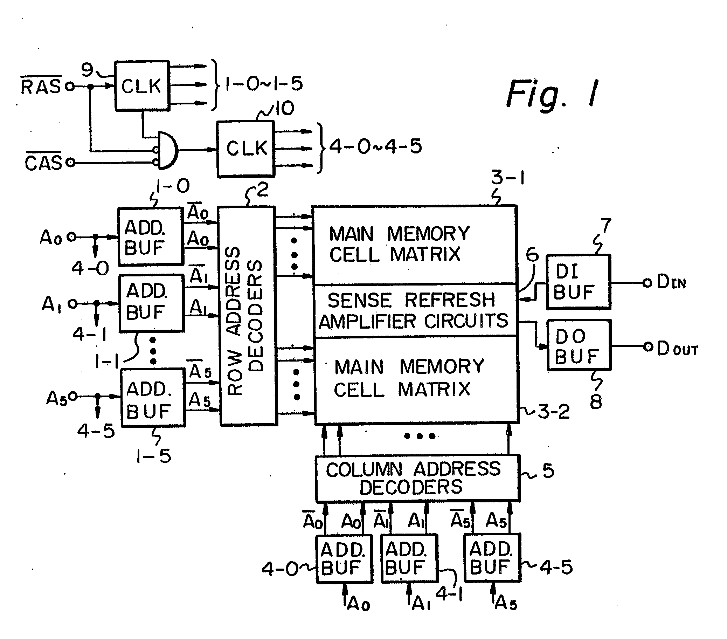

Referring to Fig. 1, which illustrates a conventional $4096(=2^{12})$ bit MOS dynamic RAM device, the device comprises row address buffer circuits 1-0, 1-1, ..., 1-5 for converting address signals $A_0$, $A_1$, ..., $A_5$ of a TTL level into address signals $A_0$, $A_1$, ..., $A_5$ of a MOS level and their inverted signals $\overline{A}_0$, $\overline{A}_1$, ..., $\overline{A}_5$, and row address decoders 2 for decoding the address signals $A_0$, $\overline{A}_0$, $A_1$, $\overline{A}_1$, ..., $A_5$, $\overline{A}_5$ (MOS level) so as to select one row from main memory cell matrixes 3-1 and 3-2. In addition, the device comprises column address buffer circuits 4-0, 4-1, ..., 4-5 for converting the address signals $A_0$, $A_1$, ..., $A_5$ (TTL level) into

address signals $A_0$, $A_1$, . . . , $A_5$ (MOS level) and their inverted signals $\overline{A}_0$, $\overline{A}_1$, . . . , $\overline{A}_5$ (MOS level) and column address decoders 5 for decoding the address signals $A_0$, $\overline{A}_0$, $A_1$, $\overline{A}_1$, . . . , $A_5$, $\overline{A}_5$ so as to select one column from the main memory cell matrixes 3-1 and 3-2. In this case, each of the main memory cell matrixes 3-1 and 3-2 comprises 2048 memroy cells; however, the matrixes 3-1 and 3-2 operate as one matrix. In addition, sense and refresh amplifier circuits 6 for sensing and refreshing the memory cells are provided between the two matrixes 3-1 and 3-2. Further, a data input buffer 7 having a terminal $D_{IN}$ and a data output buffer 8 having a terminal $D_{OUT}$ are connected to the sense and refresh amplifier circuits 6.

In the device of Fig. 1, such address signals (TTL level) are twice supplied to the device for one access thereto. Among them, a first group of the signals are used for selecting one row of the main memory cell matrixes 3-1 and 3-2, while a second group of the signals are used for selecting one column of the main memory cell matrixes 3-1 and 3-2. Such a time-divisional control of the address signals (TTL level) is effected by two clock generators 9 and 10. The clock generator 9 receives an inverted signal $\overline{RAS}$ of a row address strobe signal RAS and, in turn, generates internal clock signals for driving the row address buffer circuits 1-0, 1-1, . . . , 1-5, while the clock generator 10 receives the signal RAS, an inverted signal $\overline{CAS}$ of a column address strobe signal CAS and one internal clock signal from the clock generator 9 and, in turn, it generates internal clock signals for driving the column address buffer circuits 4-0, 4-1, . . . , 4-5. The present invention relates to the improvement of the row address buffer circuits 1-0, 1-1, . . . , 1-5 and the column address buffer ciructis 4-0, 4-1, . . . , 4-5.

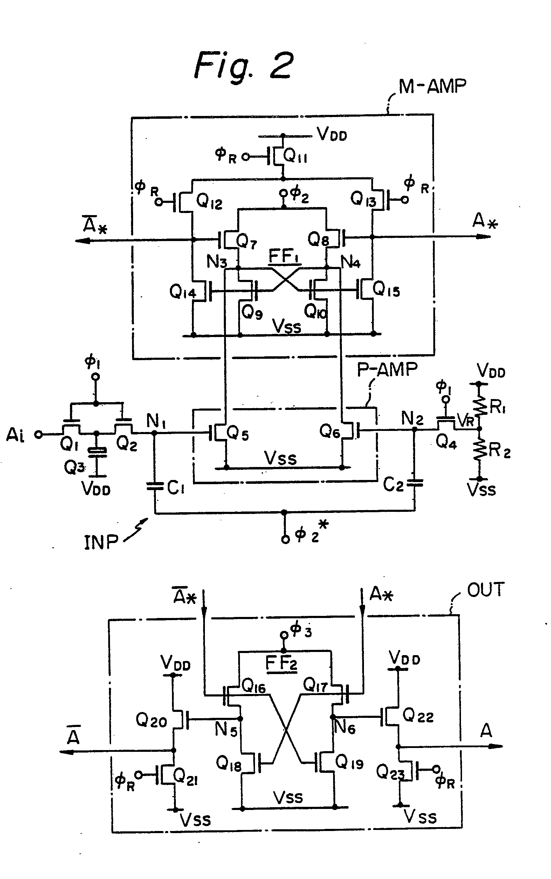

Fig. 2 is a circuit diagram illustrating a conventional address buffer circuit. This circuit converts an address signal $A_i$ of a TTL level into an address signal A of a MOS level and its inverted signal $\overline{A}$. In Fig. 2, $V_{SS}$ and $V_{DD}$ are power supplies of 0 and 5 volts, respectively, and, $\phi_1$, $\phi_2$, $\phi_2^*$, $\phi_R$ and $\phi_3$ are internal clock signals for driving the circuit of Fig. 1. These internal clock signals are generated from, for example, the clock generator 9 in Fig. 1. The circuit of Fig. 2 comprises an input circuit INP for receiving an address signal $A_i$ of a TTL level, a pre-amplifier P-AMP connected to the input circuit INP, a main amplifier M-AMP connected to the pre-amplifier P-AMP and an output circuit OUT connected to the main amplifier M-AMP.

In more detail, the input circuit INP comprises three transistors $Q_1$, $Q_2$ and $Q_4$ which serve as transfer gates, a MOS capacitor $Q_3$ for eliminating the bad effect caused by an undershoot of the address signal $A_i$, two capacitors $C_1$ and $C_2$ for raising the potentials at nodes $N_1$ and $N_2$, respectively, and two resistors $R_1$ and $R_2$ for generating a reference voltage $V_R$. In this case, the values of the resistors $R_1$ and $R_2$ are

selected in such a manner that the reference voltage $V_R$ is an intermediate value between the high and low potentials of a TTL level.

In addition, the pre-amplifier P-AMP comprises two transistors $Q_5$ and $Q_6$ which have gates connected to the nodes $N_1$ and $N_2$, respectively, sources connected to the power supply $V_{SS}$ and drains connected to the main amplifier M-AMP. On the other hand, the main amplifier M-AMP comprises a flip-flop $FF_1$ formed by four transistors $Q_7$, $Q_8$, $Q_9$ and $Q_{10}$, three transistors $Q_{11}$, $Q_{12}$ and $Q_{13}$ for presetting the potentials of output signals $A_*$ and $\overline{A}_*$ at a high level, and two transistors $Q_{14}$ and $Q_{15}$ for increasing the speed of changes of the potentials of the signals $A_*$ and $\overline{A}_*$. In the main amplifier M-AMP, nodes $N_3$ and $N_4$ of the flip-flop $FF_1$ are connected to the pre-amplifier P-AMP, while the signals $A_*$ and $\overline{A}_*$ are supplied to the output circuit OUT.

The output circuit comprises a flip-flop $FF_2$ formed by four transistors $Q_{16}$, $Q_{17}$, $Q_{18}$ and $Q_{19}$, two transistors $Q_{20}$ and $Q_{22}$ for generating output signals A and $\overline{A}$ of a MOS level, and two transistors $Q_{21}$ and $Q_{23}$ for presetting the potentials of the signals A and $\overline{A}$ at a low level ($V_{SS}$).

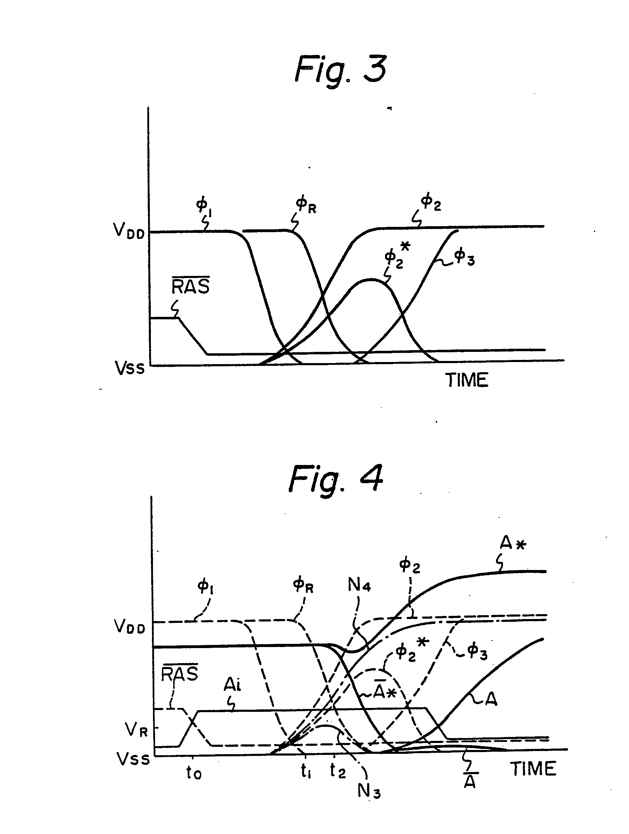

Fig. 3 is a timing diagram showing the internal clock signals $\phi_1$, $\phi_2$, $\phi_2^*$, $\phi_R$ and $\phi_3$ supplied to the circuit of Fig. 1. As illustrated in Fig. 3, firstly, the potential of the signal $\overline{RAS}$ falls so as to trigger the clock generator 9 (Fig. 1). After a predetermined time, the potentials of the clock signals $\phi_2$ and $\phi_2^*$ begin to rise towards the level $V_{DD}$, while the potential of the clock signal $\phi_R$ begins to fall. Next, after a while, the potential of the clock signal $\phi_3$ begins to rise toward the high level $V_{DD}$ and, in turn, the potential of the clock signal $\phi_2^*$ which does not yet reach the high level ($V_{DD}$) begins to fall toward the low level ($V_{SS}$).

Fig. 4 is a timing diagram showing the signals appearing in the circuit of Fig. 2. Referring to Fig. 4, the circuit of Fig. 2 will now be explained. At a time $t_0$, the potential of the address signal $A_i$ is changed from low to high. At this time, since the potential of the clock signal $\phi_1$ is high, the nodes $N_1$ and $N_2$ are charged by the signal $A_i$ and the reference voltage $V_{R1}$, respectively, so that, in the pre-amplifier P-AMP, the conductance of the transistor $Q_5$ is larger than that of the transistor $Q_6$. As a result, in the main amplifier M-AMP, the potentials at the nodes $N_3$ and $N_4$ are going to be in the low and high levels, respectively. However, actually, at this time, the potentials of the nodes $N_3$ and $N_4$ are the same as each other, since the potential of the clock signal $\phi_R$ is high. In more detail, in this case, the transistor $Q_{11}$, $Q_{12}$ and $Q_{13}$ are turned on so that the potentials of the signals $A_*$ and $A_*$ are high and accordingly, the transistors $Q_7$ and $Q_8$ are turned on. As a result, the nodes $N_3$ and $N_4$ are short-circuited. Thus, the potentials at the nodes $N_3$ and $N_4$ are both about $V_{SS}$.

It should be noted that the clock signal $\phi_R$ serves as a reset clock signal for preventing the former operation from affecting the next operation.

Next, the potential of the clock signal $\phi_1$ becomes low. As a result, the potentials at the nodes $N_1$ and $N_2$ remain at the same level.

Next, the potential of the clock signals $\phi_2$ and $\phi_2$* become high and, simultaneously, the potential of the clock signal $\phi_R$ becomes low. Therefore, due to the rising of the potential $\phi_2$*, the capacitor $C_1$ and $C_2$ increase the potentials at the nodes $N_1$ and $N_2$, respectively, so that, at a time $t_1$, such potentials become higher than the threshold voltage (which is abbreviated to $V_{th}$) of the transistors $Q_5$ and $Q_6$. Thus, the pre-amplifier P-AMP begins to operate at the time $t_1$. Simultaneously, the potentials at the nodes $N_3$ and $N_4$ become slightly higher than the level $V_{SS}$. In addition, due to the rising of the potential of the clock signal $\phi_2$, the potential at the node $N_4$ becomes high, while the potential at the node $N_3$ remains at the same level. At a time $t_2$, the flip-flop $FF_1$ begins to operate, so that the potentials at the nodes $N_3$ and $N_4$ change to the levels $V_{SS}$ and $V_{DD}$, respectively, at the end of the rising of the potential of the clock signal $\phi_2$. Concretely, at the time $t_1$, the potential of theclock signal $\phi_2$ equals, for example, 0.2 volts, while, at the time $t_2$, the potential of the clock signal $\phi_2$ equals, for example, 0.8 volts which is the threshold voltage of the transistors $Q_9$ and $Q_{10}$. As a result, the transistors $Q_{14}$ and $Q_{15}$ are turned on and off, respectively, so that the potentials of the signals $A_*$ and $\overline{A}_*$ become high and low, respectively.

In the output circuit OUT, when the potentials of the signals $A_*$ and $\overline{A}_*$ are high and low, respectively, the transistors $Q_{17}$ and $Q_{18}$ are turned on, while the transistors $Q_{16}$ and $Q_{19}$ are turned off. Next, when the potential of the clock signal $\phi_3$ begins to rise, the potential at nodes $N_6$ and $N_5$ become high and low, respectively, so that the transistors $Q_{22}$ and $Q_{20}$ are turned on and off, respectively, and accordingly, the potentials of the signals A and $\overline{A}$ become high and low, respectively.

It should be noted that, the rising of the potential of the clock signal $\phi_2$ follows the supplying of the address signal $A_i$, as explained above. Therefore, when the potential of the clock signal $\phi_2$ rises, appropriate voltages are applied to the gates of the transistors $Q_5$ and $Q_6$. As a result, the potential at the node $N_4$ rises in the same way as the clock $\phi_2$, while the potential at the node $N_3$ rises; however, immediately, returns to the low level.

In addition, since the signals $A_*$ and $\overline{A}_*$ are supplied to the flip-flop $FF_2$, prior to the rising of the clock signal $\phi_3$, a bootstrap effect causes the potential of the signal $A_*$ to be higher than that of the clock signal $\phi_2$.

Further, in the input circuit IMP of Fig. 2, the potential of the signal $A_i$ is maintained at the node $N_1$ by the transition of the potential of the clock $\phi_1$ from high to low. After that, even when the potential of the signal $A_i$ is changed, the potential at the node $N_1$ is maintained at the time $t_1$ when the pre-amplifier P-AMP begins to operate. The presence of the MOS capacitor $Q_3$ prevents an undershoot from being transmitted to the node $N_1$. In this case, if the MOS capacitor $Q_3$ is not present in the input circuit INP, the transistors $Q_1$ and $Q_2$ are turned on even if the potential of the clock $\phi_1$ is low, so that a current flows from the node $N_1$ and through the transistors $Q_2$ and $Q_1$. As a result, the potential at the node $N_1$ falls, which means that the address information is reversed. In this regard, the presence of the MOS capacitor $Q_3$ causes itself to be charged, so that the potentials of the source and drain of the transistor $Q_2$ are both high. Therefore, when an undershoot of the address signal $A_i$ is generated, the charges stored in the capacitor $Q_3$ are discharged through the transistor $Q_1$; however, the transistor $Q_2$ does not conduct. This is because, before the charges stored in the MOS capacitor $Q_3$ are discharged completely, the undershoot of the address signal $A_i$ disappears.

However, in the above-mentioned circuit of Fig. 2 are the following disadvantages.

1) The circuit is of a relatively large scale, since a large number of elements are required.

2) The operation speed of the circuit is relatively low, since, when the address signal $A_i$ is supplied to the input circuit INP, the MOS capacitor $Q_3$ and the capacitor $C_1$ which form a CR time-constant circuit are charged by the address signal $A_i$ so that the rising of the potential at the node $N_1$ is considerably slow as compared with that of the potential of the address signal $A_i$. This necessitates delaying in the initial operations of the pre-amplifier P-AMP and the main amplifier M-AMP. Otherwise, the amplifiers may be operated by an error address signal. In order to avoid this, the inputting of the address signal $A_i$ can be prior to the falling of the signal $\overline{RAS}$; however, in this case, a clock signal therefor is required. In this case, the time-period between the inputting of the address signal $A_i$ and the falling of the signal RAS is called an address setting-up time.

3) The operation of the circuit is unstable, since the reference voltage $V_R$ is dependent upon the power supply $V_{DD}$ so that the reference voltage $V_R$ is fluctuated due to the fluctuation of the power supply $V_{DD}$. Therefore, the threshold voltage of the address signal $A_i$ is dependent upon the power supply $V_{DD}$ and accordingly, it is difficult to increase the margin of the power supply $V_{DD}$. In addition, since the difference between the time $t_1$ when the pre-amplifier P-AMP is operated and the time $t_2$ when the main amplifier M-AMP is operated is relatively small as illustrated in Fig. 4, the main amplifier M-AMP may be operated before the pre-amplifier P-AMP comes into a predetermined state, which invites the malfunction of the main amplifier M-AMP.

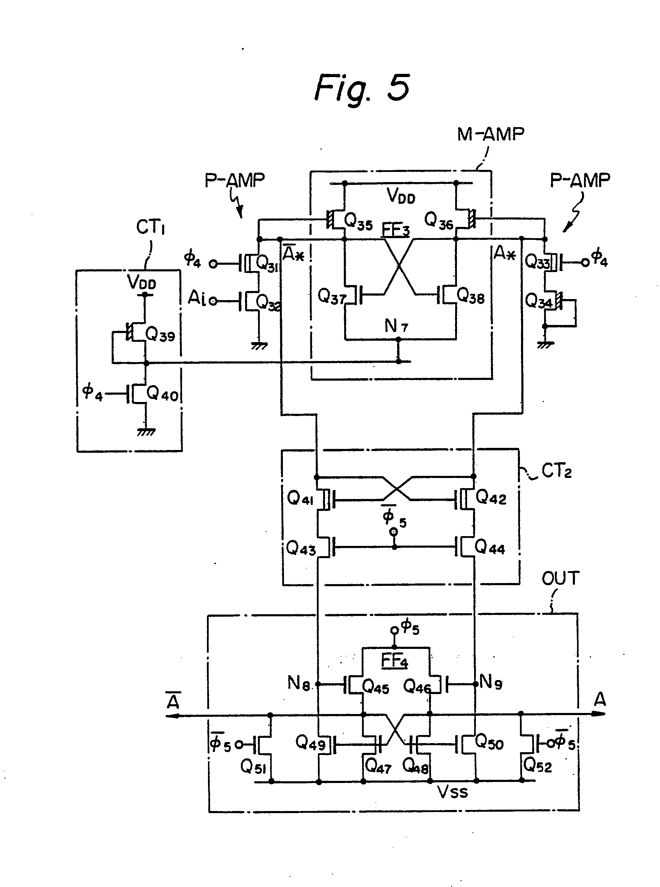

Fig. 5 is a circuit diagram illustrating an embodiment of the address buffer circuit according to the present invention. In Fig. 5, the address buffer circuit comprises a pre-amplifier P-AMP for receiving an address signal $A_i$ of a TTL level, a main amplifier M-AMP comprised of a flip-flop $FF_3$, a circuit $CT_1$ for defining the potential at a node $N_7$, and an output circuit OUT for producing address signals A and $\overline{A}$ of a MOS level. In addition, the address buffer circuit comprises a circuit $CT_2$ for charging nodes $N_8$ and $N_9$ of the output circuit OUT in the case of the stand-by state thereof and for electrically disconnecting the output circuit OUT from the main amplifier M-AMP in the case of the operation state of the output circuit OUT.

In Fig. 5, note that transistors with shaded gates are of a depletion type and other transistors are of an enhancement type. In addition, transistors with an additional line are of an enhancement type which has a relatively low threshold voltage value such as about 0.4 volts. In this case, the threshold voltage of a usual enhancement transistor is about 0.8 volts.

As illustrated in Fig. 5, the address signal $A_i$ of a TTL level is supplied directly to the pre-amplifier P-AMP, since the address buffer circuit of Fig. 5 is not provided with the input circuit INP of Fig. 2 formed by a CR time-constant circuit, so that the operation speed can be increased.

In more detail, the pre-amplifier P-AMP comprises four transistors $Q_{31}$, $Q_{32}$, $Q_{33}$ and $Q_{34}$. In this case, the conductivity of the transistor $Q_{34}$ is selected to be an intermediate value between the conductivity of the transistor $Q_{32}$ in the case where the potential of the signal $A_i$ is high, and that of the transistor $Q_{32}$ in the case where the potential of the signal $A_i$ is low. That is, the depletion type transistor $Q_{34}$ serves as a series circuit formed by the resistors $R_1$ and $R_2$ for generating the reference voltage $V_R$ in Fig. 2. In other words, a constant current flowing through the transistor $Q_{34}$ is made use of, instead of the reference voltage $V_R$ in Fig. 2. Here, a drain current is represented by

$$\frac{\beta}{2}(V_{gs} - V_{th})^2$$

where $\beta$ is a current gain; $V_{gs}$ is a gate-source voltage; and $V_{th}$ is a threshold voltage. In the case of the transistor $Q_{34}$ where the gate and the source is short-circuit, $V_{gs} = 0$. Therefore, the current flowing through the transistor $Q_{34}$ is

$$\frac{\beta}{2}V_{th}^2$$

which is a constant value independent of a power supply voltage $V_{DD}$ and the potentials of other signals, which is helpful in stabilizing the operation.

The above-mentioned pre-amplifier P-AMP is controlled by a clock signal $\phi_4$.

The main amplifier M-AMP comprises two transistors $Q_{35}$ and $Q_{36}$ of a depletion type and two transistors $Q_{37}$ and $Q_{38}$ of an enhancement type, which form the flip-flop $FF_3$. In this case, the transistors $Q_{37}$ and $Q_{38}$ are cross-coupled. The operation of the main amplifier M-AMP is controlled by the circuit $CT_1$ which, in this case, controls the potential at a node $N_7$.

The circuit $CT_1$ is comprised of a transistor $Q_{39}$ of a depletion type and a transistor $Q_{40}$ of an enhancement type which is also controlled by the clock signal $\phi_4$.

The circuit $CT_2$ is comprised of four transistors $Q_{41}$, $Q_{42}$, $Q_{43}$ and $Q_{44}$ of an enhancement type. In this case, the threshold voltages of the transistors $Q_{41}$ and $Q_{42}$ are low. In the circuit $CT_2$, when the potentials of signals $A_*$ and $\overline{A}_*$ outputted from the main amplifier M-AMP are both high, two nodes $N_8$ and $N_9$ of the output circuit OUT are charged and the potentials at the nodes $N_8$ and $N_9$ are the same. Contrary to the above, when the potentials of the signals $A_*$ and $\overline{A}_*$ are high and low, respectively, the potentials at the nodes $N_8$ and $N_9$ become low and high, respectively. However, in this case, if the potential of a clock signal $\overline{\phi}_5$ is low, the transistors $Q_{43}$ and $Q_{44}$ are turned off, so that the difference in potential between the signals $A_*$ and $\overline{A}_*$ are not transmitted to the nodes $N_8$ and $N_9$. This means that the output circuit OUT is electrically disconnected from the main amplifier M-AMP.

The output circuit OUT comprises four transistors $Q_{45}$, $Q_{46}$, $Q_{47}$ and $Q_{48}$ which form the flip-flop $FF_4$, two transistors $Q_{49}$ and $Q_{50}$, and two transistors $Q_{51}$ and $Q_{52}$ which are controlled by the clock signal $\overline{\phi}_5$. Therefore, in the stand-by state where the potential of the clock signal $\overline{\phi}_5$ is high, the potentials of the output signal A and $\overline{A}$ both remain low.

As explained above, in order to operate the address buffer circuit of Fig. 5, three clock signals $\phi_4$, $\phi_5$ and $\overline{\phi}_5$ are necessary.

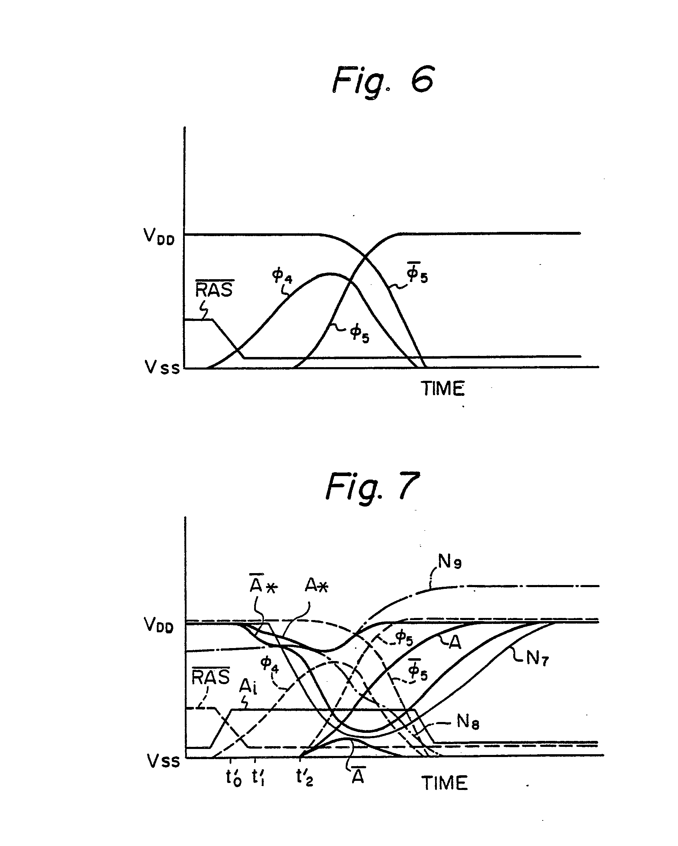

Fig. 6 is a timing diagram showing the internal clock signals supplied to the circuit of Fig. 5. As illustrated in Fig. 6, the potential of the clock signal $\phi_4$ begins to rise in association with the falling of the signal $\overline{RAS}$ and, a little later, the potential of the clock signal $\phi_4$ again returns to the low level, which is necessary for a dynamic operation of the circuit of Fig. 5. In addition, the potential of the clock signal $\phi_5$ begins to rise, while the potential of the clock signal $\overline{\phi}_5$ begins to fall as understood from Figs. 3 and 6, according to the present invention, the number of clock signals for driving the address buffer circuit is small so that control thereof can be simplified.

Fig. 7 is a timing diagram showing the signals appearing in the circuit of Fig. 5. Referring to Fig. 7, the operation of the circuit of Fig.

5 will now be explained. At a time $t_0'$, the potential of the address signal $A_i$ is changed from low to high. At this time, since the potential of the clock signal $\phi_4$ begins to rise, the potentials of the signals $A_*$ and $\overline{A}_*$ both begin to fall because of the changes of conductances in the transistors $Q_{31}$ through $Q_{34}$. In this case, since a current flowing through the transistor $Q_{32}$ is larger than the current flowing through the transistor $Q_{34}$, the potential of the signal $\overline{A}_*$ becomes lower than that of the signal $A_*$. Note that, before the time $t_0'$, the potentials of the signals $A_*$ and $\overline{A}_*$ remain at a high level due to the conductances of the transistors $Q_{35}$ and $Q_{36}$.

On the other hand, in the circuit $CT_1$, the rising of the potential of the clock signal $\phi_4$ conducts the transistor $Q_{40}$, so that the potential at the node $N_7$ falls. As a result, the main amplifier M-AMP begins to operate. Since the potential of the signal $\overline{A}_*$ is a little lower than that of the signal $A_*$, the transistors $Q_{37}$ and $Q_{38}$ are turned on and off, respectively. Therefore, the potential of the signal $\overline{A}_*$ rapidly falls due to the conduction of the transistor $Q_{37}$ which is of a relatively large scale. Although the potential of the signal $A_*$ also falls due to the conduction of the transistors $Q_{33}$ and $Q_{34}$, the potential of the signal $A_*$ again rises due to the cut-off of the transistor $Q_{38}$. Next, the potential of the clock signal $\phi_4$ again falls, so that the transistors $Q_{31}$, $Q_{33}$ and $Q_{40}$ are gradually cut off. As a result, the pre-amplifier P-AMP separates from the main amplifier M-AMP and simultaneously, the potential at the node $N_7$ rises through the depletion type transistor $Q_{39}$. Accordingly, the rising of the potential at the node $N_7$ raises the potentials of the signals $A_*$ and $\overline{A}_*$.

In the circuit $CT_2$, as explained above, when the potentials of the signal $A_*$ and $\overline{A}_*$ are both high, the nodes $N_8$ and $N_9$ of the output circuit OUT are charged by the transistors $Q_{41}$, $Q_{42}$, $Q_{43}$ and $Q_{44}$. In this state, when the potentials of the signals $A_*$ and $\overline{A}_*$ become high and low, respectively, the transistors $Q_{41}$ and $Q_{42}$ are turned on and off, respectively, so that the potentials at the nodes $N_8$ and $N_9$ become low and high, respectively. Next, when the potential of the clock signal $\phi_5$ rises, the output circuit OUT begins to operate. In this case, the conductance of the transistor $Q_{46}$ is larger than that of the transistor $Q_{45}$, so that the transistors $Q_{47}$ and $Q_{48}$ are turned on and off, respectively. Therefore, the potentials of the signals A and $\overline{A}$ become high and low, respectively. In addition, in this case, the transistors $Q_{49}$ and $Q_{50}$ are turned on and off, respectively, which promotes the lowering of the potential at the node $N_8$ and retains the high potential at the node $N_9$.

In Fig. 7, the reason why the potential at the node $N_9$ is much higher than the level $V_{DD}$ is that a bootstrap effect is generated due to the rising of the potential of the signal A. In addition, prior to the changes of the potentials of the signals A and $\overline{A}$, such potentials remain low, since the transistors $Q_{51}$ and $Q_{52}$ are

conductive due to the high potential of the clock signal $\overline{\phi}_5$.

In Fig. 5, if an undershoot of the potential of the address signal $A_i$ is generated, only the transistor $Q_{32}$ is turned off, which causes no problem.

As explained hereinbefore, the address buffer circuit according to the present invention has the following advantages as compared with the conventional circuit of Fig. 2.

1) The circuit is of a small size, since there are a smaller number of elements in Fig. 5 than in Fig. 2.

2) The operation speed becomes large, since the input circuit INP formed by a CR time-constant circuit used in Fig. 2 is unnecessary.

3) The operation of the circuit is stable. This is because, in the present invention, immediately after the potential of the lock signal $\phi_4$ rises, the pre-amplifier P-AMP begins to operate due to the presence of the transistors $Q_{31}$ and $Q_{33}$ having low threshold voltage values. In addition, since the conduction of the transistor $Q_{40}$ is later than that of the transistors $Q_{31}$ and $Q_{33}$, the falling of the potential at the node $N_7$ can be delayed. Therefore, the difference between the time $t_1'$ when the pre-amplifier P-AMP begins to operate and the time $t_2'$ when the main amplifier M-AMP begins to operate can be easily enlarged, which is helpful in the stable operation of the circuit. Further, the falling time of the potential at the node $N_7$ can be selected by changing the dimensions of the transistor $Q_{40}$. Thus, the main amplifier M-AMP begins to operate, after the pre-amplifier P-AMP comes into a predetermined state.

In addition, in the circuit $CT_2$, as explained above, the transistors $Q_{43}$ and $Q_{44}$ are controlled on and off by the clock signal $\overline{\phi}_5$. Therefore, after the output circuit OUT begins to operate, the output circuit OUT separates from the main amplifier M-AMP, which is also helpful in the stable operation of the circuit.

## Claims

1. An address buffer circuit for converting a TTL level address signal (Ai) into an MOS level address signal (A) and its inverted signal ($\overline{A}$) comprising:

first ($V_{DD}$) and second (earth) power supplies;

a pre-amplifier (P-AMP), connected to the second power supply (earth), for receiving the TTL level address signal;

a main amplifier (M-AMP) connected to outputs of the pre-amplifier and including a first flip-flop ($FF_3$);

an output circuit (OUT) coupled to outputs of the main amplifier (M-AMP) and including a second flip-flop ($FF_4$) for producing the MOS level address signal and its inverted signal, characterised in that the pre-amplifier comprises:

a first enhancement type transistor ($Q_{31}$) having its drain connected to a first input of the main amplifier (M-AMP) and its gate arranged to receive a first clock signal $(\phi_4)$;

a second enhancement type transistor $(Q_{32})$ having its drain connected to the source of the first transistor $(Q_{31})$, its source connected to the second power supply (earth) and its gate arranged to receive the TTL level address signal (Ai);

a third enhancement type transistor $(Q_{33})$ having its drain connected to a second input of the main amplifier and its gate arranged to receive the first clock signal $(\phi_4)$; and,

a fourth depletion type transistor $(Q_{34})$ having its drain connected to the source of the third transistor $(Q_{33})$ and its gate and source commonly connected to the second power supply (earth);

in that the first flip-flop $(FF_3)$ in the main amplifier (M-AMP) has a first terminal connected to the first power supply $(V_{DD})$ and a second terminal $(N_7)$;

and in that the address buffer circuit also includes:

a circuit, $(CT_1)$ connected between the first and second power supplies, for defining the potential of the second terminal $(N_7)$ of the first flip-flop $(FF_3)$; and,

a circuit $(CT_2)$ coupling the main amplifier (M-AMP) to the output circuit (OUT), the circuit $(CT_2)$ comprising transfer gate transistors $(Q_{43}, Q_{44})$ having their drains connected to the outputs of the main amplifier (M-AMP), their gates arranged to receive a second clock signal $(\phi_5)$ and their sources connected to one of the inputs of the output circuit (OUT) and charging the second flip-flop $(FF_4)$ of the output circuit (OUT) from the main amplifier (M-AMP) when the output circuit (OUT) is in a stand-by state, and electrically disconnecting the output circuit (OUT) from the main amplifier (MAMP) when the output circuit is in an active state.

2. An address buffer circuit according to claim 1, wherein the first $(Q_{31})$ and third $(Q_{33})$ transistors are of an enhancement type having relatively low threshold voltage values.

3. An address buffer circuit according to claim 1 or 2, wherein the first flip-flop $(FF_3)$ comprises:

fifth $(Q_{35})$ and sixth $(Q_{36})$ depletion type transistors having their drains connected to the first power supply $(V_{DD})$ and their gates connected to the drains of the first $(Q_{31})$ and third $(Q_{33})$ transistors respectively; and,

seventh $(Q_{37})$ and eighth $(Q_{38})$ enhancement type transistors having their drains connected to the sources of fifth $(Q_{35})$ and sixth $(Q_{36})$ transistors respectively, their sources commonly connected to the second terminal $(N_7)$ and their gates connected to the drains of the eighth $(Q_{38})$ and seventh $(Q_{37})$ transistors, respectively.

4. An address buffer circuit according to any one of the preceding claims, wherein the circuit $(CT_1)$ comprises:

a ninth $(Q_{39})$ depletion type transistor having its drain connected to the first power supply $(V_{DD})$ and its gate connected to its source and to the second terminal $(N_7)$ of the first flip-flop $(FF_3)$; and,

a tenth $(Q_{40}$ enhancement type transistor having its drain connected to the source of the ninth $(Q_{39})$ transistor, its source connected to the second power supply (earth) and its gate arranged to receive the first clock signal $(\phi_4)$.

5. An address buffer circuit according to any one of the preceding claims, wherein the circuit $(CT_2)$ also comprises:

eleventh $(Q_{41})$ and twelfth $(Q_{42})$ enhancement type transistors having relatively low values of threshold voltage each having its drain connected to one of the outputs of the main amplifier (M-AMP) and its gate connected to the drain of the other of the twelfth $(Q_{42})$ and eleventh $(Q_{41})$ transistors, respectively; and,

the transfer gate transistors $(Q_{43})$ and $(Q_{44})$ have their drains connected to the sources of the eleventh $(Q_{41})$ and twelfth $(Q_{42})$ transistors, respectively.

6. An address buffer circuit according to any one of the preceding claims, wherein the output circuit (OUT) comprises:

thirteenth $(Q_{45})$ and fourteenth $(Q_{46})$ enhancement type transistors having their drains connected together and arranged to receive a third clock signal $(\phi_5)$ which is the inverted second clock signal $(\bar{\phi_5})$, and their gates coupled to the outputs of the main amplifier (M-AMP);

fifteenth $(Q_{47})$ and sixteenth $(Q_{48})$ enhancement type transistors having their drains connected to the sources of the thirteenth $(Q_{45})$ and fourteenth $(Q_{46})$ transistors, their sources connected to the second power supply and their gates connected to the drains of the other of the sixteenth $(Q_{48})$ and fifteenth $(Q_{47})$ transistors;

seventeenth $(Q_{49})$ and eighteenth $(Q_{50})$ enhancement type transistors having their drains connected to the gates of the thirteenth $(Q_{45})$ and fourteenth $(Q_{46})$ transistors, respectively, their sources connected to the second power supply and their gates connected to the drains of the sixteenth $(Q_{48})$ and fifteenth $(Q_{47})$ transistors, respectively; and,

nineteenth $(Q_{51})$ and twentieth $(Q_{52})$ enhancement type transistors having their drains connected to the drains of the fifteenth $(Q_{47})$ and sixteenth $(Q_{48})$ transistors, their sources connected to the second power supply and their gates arranged to receive the second clock signal $(\bar{\phi_5})$.

**Revendications**

1. Circuit tampon d'addresses destiné à convertir un signal d'adresses de niveau TTL $(A_i)$ en un signal d'adresses de niveau MOS (A) et son signal inversé $(\bar{A})$, comprenant une première $(V_{DD})$ et une seconde (masse) sources d'alimentation, un pré-amplificateur (P-AMP) connecté à la seconde source d'alimentation (masse) pour recevoir le signal d'adresses de niveau TTL, un amplificateur principal (M-AMP) connecté aux sorties du pré-amplificateur et comprenant un premier circuit bistable (FF$_3$), un circuit de sortie (OUT) connecté aux sorties de l'amplificateur principal (M-AMP) et comprenant un second circuit bistable (FF$_4$) pour produire le signal d'adresse de niveau MOS et son signal inversé, caractérisé en ce que le pré-amplificateur comporte un premier transistor de type enrichi (Q$_{31}$) dont le drain est connecté à une première entrée de l'amplificateur principal (M-AMP) et dont la grille est agencée pour recevoir un premier signal d'horloge ($\phi_4$), un second transistor de type enrichi (Q$_{32}$) dont le drain est connecté à la source du premier transistor (Q$_{31}$), dont la source est connectée à la seconde source d'alimentation (masse) et dont la grille est agencée pour recevoir le signal d'adresses de niveau TTL (Ai), un troisième transistor de type enrichi (Q$_{33}$) dont le drain est connecté à une seconde entrée d'amplificateur principal et dont la grille est agencée pour recevoir le premier signal d'horloge ($\phi_4$) et un quatrième transistor de type appauvri (Q$_{34}$) dont la drain est connecté à la source du troisième transistor (Q$_{33}$) et dont la grille et la source sont connectées en commun à la seconde source d'alimentation (masse), et ce que la premier circuit bistable (FF$_3$) de l'amplificateur principal (M-AMP) comporte und première borne connectée à la première source d'alimentation (V$_{DD}$) et une seconde borne (N$_7$) et en ce que le circuit tampon d'adresses comporte également un circuit (CT$_1$) connecté entre la première et la seconde sources d'alimentation pour définir le potentiel de la seconde borne (N$_7$) du premier circuit bistable (FF$_3$) et un circuit (CT$_2$) qui couple l'amplificateur principal (M-AMP) avec le circuit de sortie (OUT), le circuit (CT$_2$) comprenant des transistors de portes de transfert (Q$_{43}$, Q$_{44}$) dont les drains sont connectées aux sorties de l'amplificateur principal (M-AMP) dont les grilles sont agencées pour recevoir un second signal d'horloge ($\overline{\phi_5}$) et dont les sources sont connectées à l'une des entrées du circuit de sortie (OUT) et chargeant le second circuit bistable (FF$_4$) du circuit (OUT) à partir de l'amplificateur principal (M-AMP) quand le circuit (OUT) est à l'état d'attente, et déconnectant électriquement le circuit de sortie (OUT) de l'amplificateur principal (M-AMP) quand le circuit de sortie se trouve dans un état actif.

2. Circuit tampon d'adresses selon la revendication 1, dans lequel le premier (Q$_{31}$) et le troisiéme (Q$_{33}$) transistors sont de type enrichi avec des valeurs de tension seuil relativement basses.

3. Circuit tampon d'adresses selon la revendication 1 ou 2, dans lequel le premier circuit bistable (FF$_3$) comporte un cinquième (Q$_{35}$), un sixième (Q$_{36}$) transistors du type appauvri dont les drains sont connectées à la première source d'alimentation (V$_{DD}$) et dont les grilles sont connectées aux drains du premier (Q$_{31}$) et du troisième (Q$_{33}$) transistors respectivement et un septième (Q$_{37}$) et un huitième (Q$_{38}$) transistors de type enrichi dont les drains sont connectées aux sources du cinquième (Q$_{35}$) et du sixième (Q$_{36}$) transistors respectivement, dont les sources sont connectées en commun à la seconde borne (N$_7$) et dont les grilles sont connectées aux drains du huitième (Q$_{38}$) et du septième (Q$_{37}$) transistors respectivement.

4. Circuit tampon d'adresses selon l'une quelconque des revendications précédentes, dans lequel le circuit (CT$_1$) comporte un neuvième (Q$_{39}$) transistor de type appauvri dont le drain est connecté à la première source d'alimentation (V$_{DD}$) et dont la grille est connectée à sa source et à la seconde borne (N$_7$) du premier circuit bistable (FF$_3$) et un dixième (Q$_{40}$) transistor de type enrichi dont le drain est connecté à la source du neuvième (Q$_{39}$) transistor, dont la source est connectée à la seconde source d'alimentation (masse) et dont la grille est agencée pour recevoir le premier signal d'horloge ($\phi_4$).

5. Circuit tampon d'adresses selon l'une quelconque des revendications précédentes, dans lequel le circuit (CT$_2$) comporte également un onzième (Q$_{41}$) et un douzième (Q$_{42}$) transistors de type enrichi ayant des valeurs relativement faibles de tension seuil avec chacun un drain connecté à une des sorties de l'amplificateur principal (M-AMP) et une grille connectée aux drains de l'autre du douzième (Q$_{42}$) et du onzième (Q$_{41}$) transistors respectivement, les drains des transistors de portes de transfert (Q$_{43}$) et (Q$_{44}$) étant connectés aux sources du onzième (Q$_{41}$) et du douzième (Q$_{42}$) transitors respectivement.

6. Circuit de tampon d'adresses selon l'une quelconque des revendications précédentes, dans lequel le circuit de sortie (OUT) comporte un treizième (Q$_{45}$) et un quatorzième (Q$_{46}$) transistors de type enrichi dont les drains sont connectées ensemble et sont agencés pour recevoir un troisième signal d'horloge ($\phi_5$) qui est le second signal d'horloge inversé ($\phi_5$) et dont les grilles sont couplées aux sorties de l'amplificateur principal (M-AMP), un quinzième (Q$_{47}$) et un seizième (Q$_{48}$) transistors de type enrichi dont les drains sont connectés aux sources des treizième (Q$_{45}$) et quatorzième (Q$_{46}$) transistors, dont les sources sont connectées à la seconde source d'alimentation et dont les grilles sont connectées aux drains de l'autre du seizième (Q$_{48}$) et du quinzième (Q$_{47}$) transistors, un dix-septième (Q$_{49}$) et un dix-huitième (Q$_{50}$) transistors de type enrichi dont les drains sont connectées aux grilles du treiziéme (Q$_{45}$) et du quatorzième (Q$_{46}$) transistors respectivement, dont les sources sont connectées à la seconde source d'alimentation et dont les grilles sont connectées aux drains du seizième (Q$_{48}$) et du quinzième (Q$_{47}$) transistors respectivement et un dix-neuvième (Q$_{51}$) et un vingtième (Q$_{52}$) transistors de type enrichi dont les drains sont connectés aux drains du quinzième (Q$_{47}$) et du seizième (Q$_{48}$) transistors dont les sources sont connectées à la seconde source d'alimentation et dont les grilles sont agencées pour recevoir le second signal d'horloge ($\phi_5$).

## Patentansprüche

1. Adressenpufferschaltung zur Konvertierung eines TTL-Pegel-Adressensignals (Ai) in ein MOS-Pegel-Adressen-signal (A) und sein invertiertes Signal ($\overline{A}$), mit:

einem ersten ($V_{DD}$) und einem zweiten (Erde) Energieversorgungsanschluß,

einem Vorverstärker (P-AMP), der mit dem zweiten Energieversorgungsanschluß (Erde) verbunden ist, zum Empfang des TTL-Pegel-Adressensignals,

einen Hauptverstärker (M-AMP) der mit den Ausgängen des Vorverstärkers verbunden ist und eine erstes Flipflop ($FF_3$) umfaßt,

einer Ausgangschaltung (OUT), die mit den Ausgängen des Hauptverstärkers (M-AMP) verbunden ist und ein zweites Flipflop ($FF_4$) umfaßt, um das MOS-Pegel-Adressensignal und sein invertiertes Signal zu erzeugen,

dadurch gekennzeichnet, daß der Vorverstärker umfaßt:

einen ersten Transistor ($Q_{31}$) vom Anreicherungstyp, dessen Drain mit einem ersten Eingang des Hauptverstärkers (M-AMP) verbunden und dessen Gate so angeordnet ist, daß es ein erstes Taktsignal ($\phi_4$) empfängt,

einen zweiten Transistor ($Q_{32}$) vom Anreicherungstyp, dessen Drain mit der Source des ersten Transistors ($Q_{31}$) verbunden ist und dessen Source mit dem zweiten Energieversorgungsanschluß (Erde) verbunden ist und dessen Gate so angeordnet ist, daß es das TTL-Pegel-Adressensignal (Ai) empfängt,

einen dritten Transistor ($Q_{33}$) vom anreicherungstyp, dessen Drain mit einem zweiten Eingang des Hauptverstärkers verbunden und dessen Gate so angeordnet ist, daß es das erste Taktsignal ($\phi_4$) empfängt, und

einen vierten Transistor ($Q_{34}$) vom Verarmungstyp, dessen Drain mit der Source des dritten Transistors ($Q_{33}$) verbunden ist, und dessen Gate und Source gemeinsam mit dem zweiten Energieversorgungsanschluß (Erde) verbunden sind,

daß das erste Flipflop ($FF_3$) in dem Hauptverstärker (M-AMP) einen ersten Anschluß, der mit dem ersten Energieversorgungsanschluß ($V_{DD}$) verbunden ist, und einen zweiten Anschluß ($N_7$) hat,

und daß die Adressenpufferschaltung ebenfalls umfaßt:

eine Schaltung ($CT_1$), die zwischen dem ersten und dem zweiten Energieversorgungsanschluß angeschlossen ist, um das Potential des zweiten Anschlusses ($N_7$) des ersten Flipflops ($FF_3$) zu definieren, und

eine Schaltung ($CT_2$), welche des Hauptverstärker (M-AMP) mit der Ausgangsschaltung (OUT) verbindet, wobei die Schaltung ($CT_2$) Transfertor-Transistoren ($Q_{43}$, $Q_{44}$)

umfaßt, deren Drains mit den Ausgängen des Hauptverstärkers (M-AMP) verbunden sind, deren Gates so angeordnet sind, daß sie eine zweites Taktsignal ($\overline{\phi_5}$) empfangen und deren Source jeweils mit einem der Eingänge der Ausgangsschaltung (OUT) verbunden sind, und das zweite Flipflop ($FF_4$) der Ausgangsschaltung (OUT) von dem Hauptverstärker (M-AMP) lädt, wenn die Ausgangsschaltung (OUT) in einem stand-by-Zustand ist, und die Ausgangsschaltung (OUT) elektrisch von dem Hauptverstärker (M-AMP) trennt, wenn die Ausgangsschaltung in einem aktiven Zustand ist.

2. Adressenpufferschaltung nach Anspruch 1, bei welcher der erste Transistor ($Q_{31}$) und der dritte Transistor ($Q_{33}$) vom Anreicherungstyp sind und relativ niedrige Schwellenspannungswerte haben.

3. Adressenpufferschaltung nach Anspruch 1 oder 2, bei welcher das erste Flipflop ($FF_3$) umfaßt:

einen fünften Transistor ($Q_{35}$) und einen sechsten Transistor ($Q_{36}$) vom Verarmungstyp, deren Drains mit dem ersten Energieversorgungsanschluß ($V_{DD}$) und deren Gates mit den Drainelektroden des ersten Transistors ($Q_{31}$) bzw. des dritten Transistors ($Q_{33}$) verbunden sind, und

einen siebten Transistors ($Q_{37}$) und einen achten Transistor ($Q_{38}$) vom Anreicherungstyp, deren Drains mit der Sourceelektrode des fünften Transistors ($Q_{35}$) bzw. des sechsten Transistors ($Q_{36}$) verbunden sind, deren Sourceelektroden gemeinsam mit dem zweiten Anschluß ($N_7$) verbunden sind und deren Gates mit den Drains des achten Transistors ($Q_{38}$) bzw. des siebten Transistors ($Q_{37}$) verbunden sind.

4. Adressenpufferschaltung nach einem der vorhergehenden Ansprüche, bei welcher die Schaltung ($CT_1$) umfaßt:

einen neunten Transistor ($Q_{39}$) vom Verarmungstyp, dessen Drainelektrode mit dem ersten Energieversorgungsanschluß ($V_{DD}$) und dessen Gate mit seiner Source und mit dem zweiten Anschluß ($N_7$) des ersten Flipflops ($FF_3$) verbunden sind, und

einen zehnten Transistor ($Q_{40}$) vom Anreicherungtyp, dessen Drain mit der Source des neunten Transistors ($Q_{39}$) verbunden ist, dessen Source mit dem zweiten Energieversorgungsanschluß (Erde) verbunden ist, und dessen Gate so angeordnet ist, daß es das erste Taktsignal ($\phi_4$) umfaßt.

5. Adressenpufferschaltung nach einem der vorhergehenden Ansprüche, bei welcher die Schaltung ($CT_2$) ferner umfaßt:

einen elften Transistor ($Q_{41}$) und einen zwölften Transistors ($Q_{42}$) vom Anreicherungstyp, welche relativ niedrige Schwellenspannungswerte aufweisen und deren Drain jeweils mit einem der Ausgänge des Hauptverstärkers (M-AMP) und deren Gate mit dem Drain des jeweils anderen zwölften ($Q_{42}$) bzw. elften ($Q_{41}$) Transistors verbunden ist,

und deren Transfertor-Transistoren ($Q_{43}$) und

($Q_{44}$) Drains umfassen, die mit den Sourceelektroden des elften ($Q_{41}$) bzw. zwölften Transistors ($Q_{42}$) verbunden sind.

6. Adressenpufferschaltung nach einem der vorhergehenden Anspruche, bei welcher die Ausgangsschaltung (OUT) umfaßt:

einen dreizehnten Transistor ($Q_{45}$) und einen vierzehnten Transistor ($Q_{46}$) vom Anreicherungstyp, deren Drains miteinander verbunden und so angeordnet, sind, daß sie ein drittes Taktsignal ($\phi_5$) empfangen, welches das invertierte zweite Taktsignal ($\overline{\phi_5}$) ist, und deren Gates mit den Ausgängen des Hauptverstärkers (M-AMP) verbunden sind,

einen fünfzehnten Transistor ($Q_{47}$) und einen sechzenten Transistor ($Q_{48}$) vom Anreicherungstyp, deren Drains mit den Sourceelektroden des dreizehnten ($Q_{45}$) und vierzehnten Transistors ($Q_{46}$) verbunden sind, deren Sourceelektroden mit dem zweiten Energieversorgungsanschluß verbunden sind und deren Gateelektroden mit dem Drain des anderen sech-

zehnten Transistors ($Q_{48}$) bzw. des fünfzehnten Transistors ($Q_{47}$) verbunden sind,

einen siebzehnten Transistor ($Q_{49}$) und einen achtzehnten Transistor ($Q_{50}$) vom Anreicherungstyp, deren Drainelektroden mit den Gateelektroden des dreizehnten ($Q_{45}$) bzw. vierzehnten ($Q_{46}$) Transistors verbunden sind, deren Sourceelektroden mit dem zweiten Ergieversorgungsanschluß und deren Gateelektroden mit den Drainelektroden des sechzehnten ($Q_{48}$) bzw. fünfzehnten Transistor ($Q_{47}$) verbunden sind,

einen neunzehnten Transistor ($Q_{51}$) und einen zwanzigsten Transistor ($Q_{52}$) vom Anreicherungstyp, deren Drainelektroden mit den Drainelektroden des fünfzehnten ($Q_{47}$) und sechzehnten ($Q_{48}$) Transistors verbunden sind, deren Sourceelektroden mit dem zweiten Energieversorgungsanschluß verbunden sind und deren Gates so angeordnet sind, daß sie das zweite Taktsignal ($\overline{\phi_5}$) ampfangen.

Fig. 1

0 036 743

# Fig. 2

# Fig. 3

# Fig. 4

# Fig. 5

4

## Fig. 6

## Fig. 7